# EUROPEAN PATENT APPLICATION

(11) **EP 1 650 816 A1**
(43) Date of publication of application: **26.04.2006**
(21) Application number: 04256511.9
(22) Date of filing: 22.10.2004
(51) Int. Cl.: H01L 41/083, H01L 41/047, F02M 51/06

(54) **Piezoelectric actuator**

(71) Applicant: Delphi Technologies, Inc., Troy, MI 48007 (US)
(72) Inventor: Redding, Keith, Gillingham Kent ME8 0PE (GB)
(74) Representative: Hopley, Joanne Selina

(57) **Abstract**

A piezoelectric actuator (28) comprises a stack body (30) including a plurality of piezoelectric elements (32), each element having a positive and negative electrode pair (40a, 40b) which are electrically isolated from one another by the piezoelectric element (32), positive contact means (44) in electrical connection with the positive internal electrodes (40a) of the pairs and negative contact means (44) in electrical connection with the negative internal electrodes (40a) of the pairs. First and second charge distribution means (42, 48) are connectable with a power supply, in use, to permit voltage to be applied across the stack body (30). Each of the first and second charge distribution means (42) includes a distribution member (48) coupled electrically to the respective one of the positive or negative contact means (44) by means of a plurality of flexible conductor members (50). The flexible conductor members ensure that any contraction and/or expansion of the contact means (44) as the stack body (30) contracts/expands does not result in any disconnection to the internal electrodes which would otherwise affect actuator performance.

## Description

The invention relates to a piezoelectric actuator and more particularly, but not exclusively, to a piezoelectric actuator suitable for use in a fuel injector of a compression-ignition internal combustion engine. The invention also relates to a fuel injector of the aforementioned type, in which a piezoelectric actuator is implemented to control an injector valve needle.

Known piezoelectric fuel injectors may employ a piezoelectric actuator having a stack of piezoelectric elements for opening and closing an injector valve needle to meter fuel injected into the engine. The valve needle is coupled to the piezoelectric actuator through a mechanical and/or hydraulic coupling so that extension and contraction of the piezoelectric stack, in use, results in controlled movement of the valve needle. An example of a piezoelectric fuel injector of this type is disclosed in U.S. Patent No. 6520423.

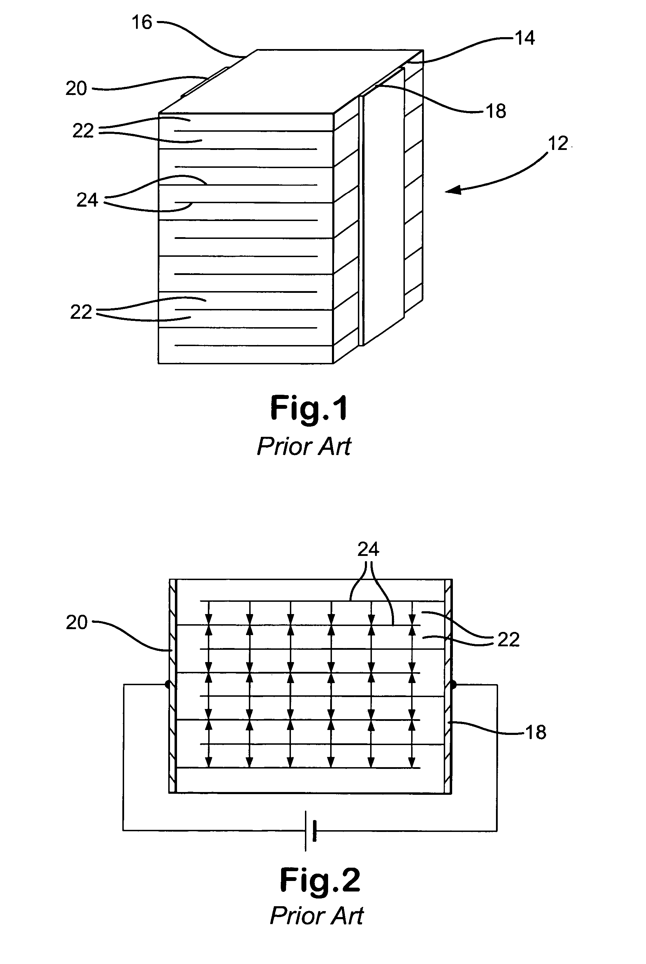

A typical multi-layer piezoelectric actuator is shown in Figure 1 and includes a generally rectangular stack body 12 having first and second opposing outer side faces 14, 16 and associated first and second side-mounted external conductors 18, 20. The body 12 comprises a plurality of relatively thin piezoelectric elements or layers 22, each of which is spaced from adjacent elements 22 by an internal electrode 24 in a mutually planar relationship. Alternate ones of the internal electrodes 24 are electrically connected to the first external conductor 18 and second external conductor 20, respectively, so as to form two groups of electrodes, whereby the electrodes of one group are interdigitated with the electrodes of the other group.

With reference to Figure 2, a voltage is applied, in use, across the external conductors 18, 20, whereby an adjacent pair of internal electrodes 24 sandwiching an intermediate piezoelectric element 22 become mutual conductors of opposite polarity and apply an electric field to the intermediate element 22. Put another way, the external conductors 18, 20 serve to distribute charge to each group of the internal electrodes 24 to which they are connected. When an electric field is applied to the external conductors 18, 20, the piezoelectric actuator will elongate (if the piezoelectric actuator is of the energise-to-extend type) or contract (if the piezoelectric actuator is of the de-energise-to-extend type) along its longitudinal axis. It should be noted that, for the present purposes, the longitudinal axis is to be construed as normal to the parallel planes in which the internal conductors 24 and the piezoelectric elements 22 lie.

Common to actuators of the type described above is the need to connect the external conductors 18, 20 to the structure of internal electrodes 24, the edges of which emerge at alternate opposing faces of the stack body 12. It is known to connect the conductors 18, 20 and the internal electrodes 24 rigidly, for example by soldering or through the use of a conductive adhesive. However, since the relative separation of each internal electrode 24 varies during operation of the stack body, the conductors 18, 20 are subject to considerable stresses as they are stretched and compressed due to expansion and contraction of the stack body 12. As a result, it is possible for the conductors 18, 20 to fail at these stress points so causing a break in the electrical circuit. The electrodes 24 located downstream of the failure point will not be subject to the voltage that is applied to the conductors 18, 20, with the result that the affected piezoelectric elements 22 become non-operational. Consequently, maximum linear actuation of the actuator 12 is reduced. In view of the high precision control required for the injector valve needle, any loss of actuation stroke is a serious problem.

It is with a view to avoiding or at least alleviating the above mentioned problem that the present invention has been devised. According to a first aspect of the invention, a piezoelectric actuator includes a stack body having a plurality of piezoelectric elements, each element having a positive and negative electrode pair which are electrically isolated from one another by the piezoelectric element, positive contact means in electrical connection with the positive internal electrodes of the pairs and negative contact means in electrical connection with the negative internal electrodes of the pairs. First and second charge distribution means are provided which are connectable with a power supply, in use, to permit voltage to be applied across the stack body. Each of the first and second charge distribution means includes a distribution member coupled electrically to the respective one of the positive or negative contact means by means of a plurality of flexible conductor members which serve to absorb expansion and contraction of the stack body, in use.

The provision of the flexible conductor members avoids problems associated with electrical disconnection between regions of the contact means and the charge distribution means in circumstances in which the contact means become cracked due to expansion and/or contraction of the stack body. As the stack body extends and contracts, in use, the conductor members absorb the corresponding extension and contraction of the contact means. Should one of the flexible members break as a result, contact is maintained between the distribution member and the contact means by virtue of the remaining conductor members. The invention therefore improves actuator reliability.

Preferably, the distribution member is attached rigidly to the associated one of said contact means only along an edge of the distribution member, for example an upper or lower edge of the distribution member. This ensures that any expansion and contraction of the contact means does not give rise to stresses within the distribution member, which may otherwise cause damage or breaking of the electrical connection between the distribution member and the contact means.

The distribution member typically takes the form of, or includes, a bus bar in contact with an associated one of the contact means. In a preferred embodiment, the bus bar overlays the associated one of said contact means so as to divide said contact means into first and second side contact zones, one on either side of the bus bar. Preferably, the bus bar overlays the contact means substantially centrally to divide the contacts means into two approximately equal side contact zones.

In a preferred embodiment, each of the flexible conductor members is an electrically conducting strip or wire.

In a further preferred embodiment, the flexible conductor members extend diagonally across a face of the stack body. By virtue of the strips being disposed diagonally across the face of the stack body, the strips may have a greater length than if they were mounted transversely (i.e. in a plane parallel to the planes in which the internal electrodes lie). Therefore, if both ends of the strips are connected to the contact means, a relatively large distance exists between the contacts points at which the strip ends are attached. A particular benefit of this arrangement is that stresses and strains induced in the strips by movement of the stack body remain within the mechanical tolerances of the material so that damage to the strips, and hence disconnection of the strips, does not occur.

In an alternative embodiment, the distribution member overlays one side region of the contact means so as to leave exposed a region or zone of the contacts means for connection with the flexible conductor members.

In a further preferred embodiment, each strip includes a bridging part which overlays the bus bar and wherein each strip includes a first strip end which makes contact with a respective one of said contact zones of the associated one of said contact means.

Typically, the strips are connected electrically to the bus bar by means of weld contacts. Likewise, the strips ends may be connected electrically to the contact zones by means of weld contacts.

Preferably, the bus bar extends substantially along a longitudinal axis of the stack body.

In a preferred embodiment, the distribution member and the plurality of conductor members are housed, together with the stack body and said contact means, within an outer actuator sleeve or housing suitable for receipt within a fluid-filled volume, in use (e.g. a fuel-filled accumulator volume of a piezoelectrically controlled fuel injector).

According to a second embodiment of the invention, there is provided a fuel injector for use in a compression ignition internal combustion engine, the fuel injector including a piezoelectric actuator in accordance with the first aspect of the invention, the actuator being arranged to control movement of an injector valve needle.

Preferred and/or optional features of the first aspect of the invention may be included in the second aspect of the invention also.

In order that the invention may be more readily understood, reference will now be made, by way of example only, to the accompanying drawings in which:
Figure 1 is a perspective view of a known multi-layer piezoelectric actuator;
Figure 2 is a schematic front view of the piezoelectric actuator in Figure 1;
Figure 3 is a perspective view of a piezoelectric actuator in accordance with an embodiment of the present invention;
Figure 4 is a side view of the piezoelectric actuator in Figure 3;
Figure 5 is a top view of part of the piezoelectric actuator in Figure 3; and
Figure 6 is a side view of part of the piezoelectric actuator in Figure 3.

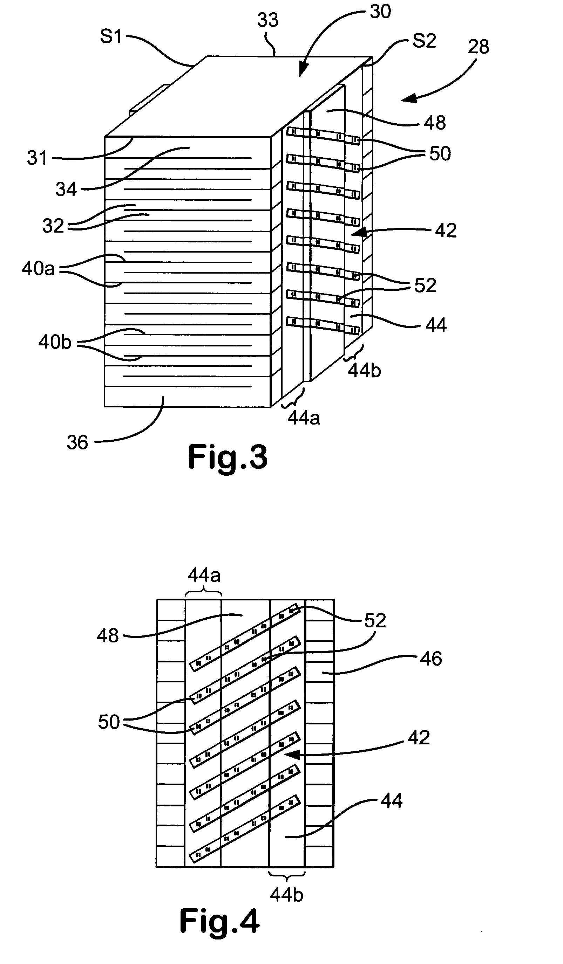

Referring to Figures 3, 4 and 5, there is shown a piezoelectric actuator 28 having front rear faces 31, 33 and opposing side faces S1, S2. The stack body 30 comprises a plurality of piezoelectric layers or elements 32 disposed between first and second actuator end pieces 34, 36 in the form of plates or tiles. It will appreciated that although the stack body 30 is described with reference to its front, rear, and opposing side faces 31, 33, S1, S2, this should not be construed as limiting the stack body 30 to a particular orientation. Furthermore, it should be noted that the dimensions of the stack and associated components are exaggerated in the figures for the sake of clarity and, in practice, the stack body 30 comprises in the order of hundreds of piezoelectric elements 32. When in use within a fuel injector, the actuator 28 may be housed within an accumulator volume, or stack chamber, which contains fuel at high pressure. Typically, therefore, a sealing sleeve is provided to prevent the ingress of fuel into the stack body 30.

Adjacent elements 32 of the stack body 30 are spaced apart by positive and negative internal electrodes 40a, 40b arranged so as to be substantially co-planar to the first and second end pieces 34, 36. Respective charge distribution electrodes, referred to generally as 42, are affixed to each opposing side face S1, S2 of the stack body 30 and serve to distribute charge from a power supply (not shown) to the internal electrodes 40a, 40b.

In a conventional manner, the elements 32 and the internal electrodes 40a, 40b are arranged, or stacked, in such a way that alternate ones of the electrodes 40a, 40b form a first group of electrodes. Remaining alternate ones of the electrodes 40a, 40b form a second group of electrodes, whereby the electrodes 40a of the first group are interdigitated with the electrodes 40b of the second group. The first group of electrodes 40a may be considered to be the positive group of electrodes (for connection with a positive side of a voltage supply) and the second group of electrodes 40b may be considered to be a negative group of electrodes (for connection with a negative side of a voltage supply).

The edge of each electrode 40a, 40b within a common group emerges at a respective side face S1, S2 of the stack body 30. In other words, the edge of each electrode 40a in the first group emerges at the side face S 1 and the edge of each electrode 40b in the second group emerges at the side face S2. This configuration of the electrodes 40a, 40b provides a means by which they may be connected to a source of power (not shown) by applying an electrical contact means 44 to the stack side faces S1, S2. To this end, first and second contact layers 44 (only one of which is visible in the figures) extend along the longitudinal axis of a respective side faces S1, S2. Thus, the first contact layer 44 serves to connect with the edges of the first group of internal electrodes 40a and the second contact layer 44 serves to connect with the edges of the second group of internal electrodes 40b. Each contact layer 44 substantially covers the respective side face S1, S2 of the stack body 30, except for first and second uncovered zones or regions 46 disposed along the long edge of each face S1, S2.

The first and second contact layers 44 may take the form of epoxy layers or, alternatively, may be formed from a silver-filled glazed material. Other materials of similar electrical and structural properties may also be used.

The charge distribution means include first and second charge distribution means 42, each of which is coupled to a respective one of the first and second contact layers 44 and provide a means by which a voltage may be applied to the layers 44. In other words, two distribution means 42 are provided, a first one being attached to one of the side faces S1 and a second one being attached to the other side face S2. For simplicity, only one of the distribution means 42 (for side face S2) shall be described in detail below.

The distribution means 42 includes a rigid distribution member in the form of a bus bar 48 which overlays a portion of the contact layer 44 so that a longitudinal axis of the bus bar 48 aligns with a central, longitudinal axis of the contact layer 44 and of the side face S2. The bus bar 48 is attached to the contact layer 44 at its upper edge, and only at its upper edge, and extends along the longitudinal axis of the side face S2 to its bottom edge. This arrangement permits a degree of axial movement between the contacted parts 44, 48, as discussed further below.

The positioning of the bus bar 48 on the contact later 44 divides the contact layer 44 into first and second side contact or attachment zones 44a, 44b, one zone being located on each side of the bus bar 48 (as shown most clearly in Figure 4). It is preferred that the bus bar 48 is made from a controlled expansion alloy such as INVAR (RTM) which provides a linear, and therefore predictable, expansion across a wide temperature range. The selection of INVAR is also appropriate as it has similar thermal expansion properties to ceramic materials, from which the stack is formed. Alternative controlled expansion materials having the appropriate properties may also be used.

A plurality of interconnecting conductor members 50 are connected across the contact zones 44a, 44b of the contact layer 44. The interconnecting conductor members 50 may take the form of gold strips and function to connect electrically the bus bar 48 to the contact layer 44 at a plurality of separate and distinct points (or zones) of contact along the strip length, but not at all points along the strip length. The connection between each conductor member 50 and the bus bar 48 is thus not a rigid connection. The strips 50 may be formed from gold or INVAR, for example, or any other material having properties which allow stresses within the material to dissipate.

Each strip 50 takes the form of a bridge-like structure which extends diagonally across, so as to overlay, the width of the bus bar 48. A first end of each strip 50 is attached to the first contact zone 44a and a second end of each strip 50 is attached to the second contact zone 44b. The diagonal configuration of each strip 50 means that the first end of a strip attaches to an axially lower contact zone 44a and the second end of the strip attaches to an axially higher contact zone 44b, with reference to the longitudinal axis of the stack body 30 being vertically aligned. The attachment of the strip 50 to each contact zone 44a, 44b is formed by means of welding at weld points 52. The bridging part of the strip 50 is attached to the bus bar 48 by means of welding at weld points 52. In the illustration shown, the bridging part of the strip 50 is attached to the bus bar 48 at two weld points 52, although in practice a different number of weld points may be used for the bridging part.

By virtue of the above arrangement, the strips 50 serve to distribute charge to the contact layer 44 at a plurality of contact points, thus effectively dividing the contact layer 44 into a plurality of electrical contact zones. Furthermore, the strips are capable of "flexing" to some degree so as compensate for the relative movement between the piezoelectric elements 32 during actuator operation. As the strips 50 absorb the expansion and contraction of the stack body 30 relative to the bus bar 48, and as the bus bar 48 is only attached to the stack body 30 along an upper edge of the bus bar 48, the bus bar 48 is isolated, and hence protected, from this movement.

It will be appreciated that the bus bar 48 is held in place on the contact layer by virtue of the actuator sleeve (not shown) which surrounds the complete assembly when fully assembled. The contact layers 44, the bus bar 42 and the flexible conductor members 50 are thus all housed within the actuator sleeve, so as to be protected from fuel within the surrounding fuel volume.

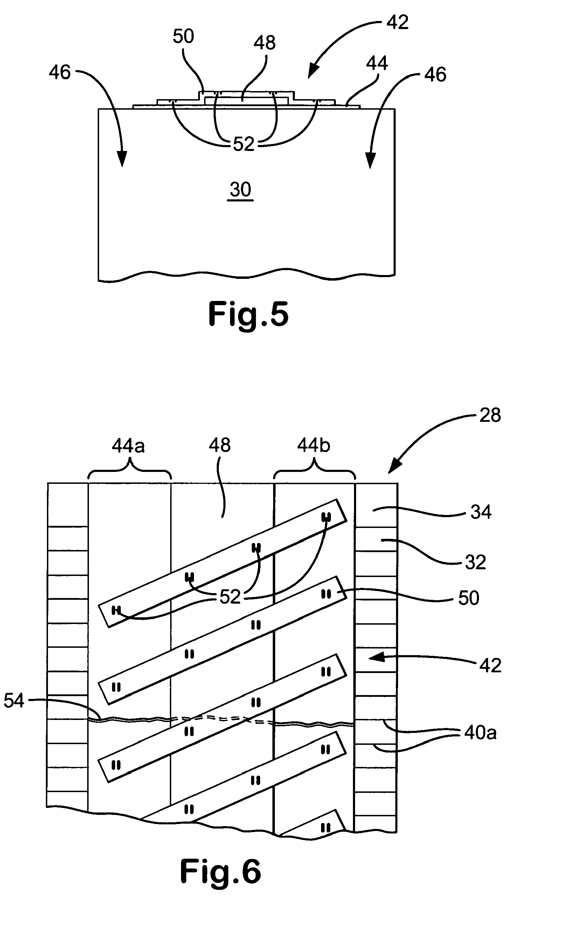

In use, as a voltage is applied across the piezoelectric actuator 28 to cause extension and contraction of the stack body 30, the contact layer 44, being directly in attachment with the body 30, will be subjected to the relative movement of the piezoelectric layers 32. It is possible that over time a crack 54 may develop in the contact layer 44 as expansion and contraction occurs during actuator operation. Such a crack may progress across the contact layer 44 so as to divide the contact layer 44 into two or more electrically isolated regions, as illustrated in Figure 6. In this were to occur, however, the present invention provides the benefit that the strips 50 continue to distribute charge/current to each divided contact layer region. The plurality of connections between the bus bar 48 and the contact layer 44 thus enable a supplied voltage to be delivered beyond the crack 54. Actuator functionality is therefore maintained.

It will be understood by those who practice the invention and those skilled in the art, that various modifications and improvements may be made to the invention without departing from the scope of the invention, as defined by the claims. Accordingly, reference should be made to the claims and other conceptual statements in determining the scope of the invention. For example, although the bus bar 48 is described as being attached to the upper edge of the side face S2, the bus bar 48 may alternatively be attached at any point along the length of the contact layer 44. In addition, although in practice it is convenient for the bus bar 48 to extend centrally along the longitudinal axis of the contact layer 44, it may as an alternative be offset to one side of the contact layer 44.

## Claims

1. A piezoelectric actuator (28) comprising:
a stack body (30) including a plurality of piezoelectric elements (32), each element having a positive and negative electrode pair (40a, 40b) which are electrically isolated from one another by the piezoelectric element (32);
positive contact means (44) in electrical connection with the positive internal electrodes (40a) of the pairs and negative contact means (44) in electrical connection with the negative internal electrodes (40a) of the pairs; and
first and second charge distribution means (42, 48) being connectable with a power supply, in use, to permit voltage to be applied across the stack body (30),
**characterised in that** each of the first and second charge distribution means (42) includes a distribution member (48) coupled electrically to the respective one of the positive or negative contact means (44) by means of a plurality of flexible conductor members (50) which serve to absorb expansion and contraction of the stack body (30), in use.

2. The piezoelectric actuator (28) as claimed in Claim 1, wherein the distribution member (48) is in secure connection with the associated contact means (44) only along one edge of said distribution member (48).

3. The piezoelectric actuator (28) as claimed in Claim 1 or Claim 2, wherein the plurality of conductor members (50) extend diagonally across a face (S1, S2) of the stack body (30).

4. The piezoelectric actuator (28) as claimed in any one of Claims 1 to 3, wherein each of the plurality of conductor members is an electrically conducting

5. The piezoelectric actuator (28) as claimed in any one of Claims 1 to 4, wherein the distribution member includes a bus bar (48) which overlays a respective one of said contact means (44).

6. The piezoelectric actuator (28) as claimed in Claim 5, wherein the bus bar overlays one side edge of the associated one of said contact means (44), to leave a zone of the contact means exposed for connection with the plurality of conductor members (50).

7. The piezoelectric actuator (28) as claimed in Claim 5, wherein the bus bar (48) overlays the associated one of said contact means (44) so as to divide said contact means into first and second side contact zones (44a, 44b) exposed for connection with the plurality of conductor members (50).

8. The piezoelectric actuator (28) as claimed in Claim 7, wherein each strip (50) includes a bridging part which overlays the bus bar (48), each strip (50) further comprising a first end which makes contact with one of the side contact zones (44a, 44b) and a second end which makes contact with the other of the side contact zones (44a, 44b).

9. The piezoelectric actuator (28) as claimed in Claim 7 or Claim 8, wherein the strips (50) are connected electrically to the bus bar (48) by means of weld contacts.

10. The piezoelectric actuator (28) as claimed in Claim 8 or Claim 9, wherein the first and second strips ends are connected electrically to the contact zones (44a, 44b) by means of weld contacts.

11. The piezoelectric actuator (28) as claimed in any one of Claims 5 to 10, wherein the bus bar (48) extends substantially along a longitudinal axis of the stack body (30).

12. The piezoelectric actuator (28) as claimed in any one of Claims 1 to 11, wherein the stack body (30) comprises first and second side faces (S1, S2) and wherein each of the positive and negative contact means (44) includes a layer of conductive material disposed on a respective one of the first and second side faces (S1, S2).

13. The piezoelectric actuator (28) as claimed in any one of Claims 1 to 12, wherein the distribution member (48) and the plurality of conductor members (50) are housed, together with the stack body (30) and said contact means (44), within an outer actuator sleeve or housing suitable for receipt within a fluid-filled volume, in use.

14. A fuel injector for use in a compression ignition internal combustion engine, the injector including a piezoelectric actuator (28) as claimed in any one of Claims 1 to 13.
